Europäisches Patentamt

European Patent Office

Office européen des brevets

(11) Publication number: **0 094 140**
**A1**

(19)

(12) **EUROPEAN PATENT APPLICATION**

(21) Application number: **83200686.0**

(22) Date of filing: **16.02.81**

(51) Int. Cl.³: **G 06 F 3/04**

(30) Priority: **11.02.80 US 120272**
**11.02.80 US 120271**
**11.02.80 US 120291**
**11.02.80 US 120292**

(43) Date of publication of application: **16.11.83**
**Bulletin 83/46**

(84) Designated Contracting States: **CH DE FR GB IT LI NL SE**

(60) Publication number of the earlier application in accordance with Art. 76 EPC: **0035334**

(71) Applicant: **DATA GENERAL CORPORATION, Route 9, Westboro Massachusetts 01581 (US)**

(72) Inventor: **Bernstein, David H., 41 Bay Colony Drive, Ashland Massachusetts 01721 (US)**
Inventor: **Carberry, Richard A., 10082 Firwood Drive, Cupertino California 95014 (US)**
Inventor: **Druke, Michael B., 32 Longmeadow Road, Chelmsford Massachusetts 01824 (US)**
Inventor: **Gusowski, Ronald I., 5 Baxter Street, Westbro Massachusetts 01581 (US)**
Inventor: **Buckley, Edward M., 68 Dutcher Street, Hopedale Massachusetts 01747 (US)**
Inventor: **March, Roger W., 3422 Georgetown Place, Santa Clara California 95051 (US)**

(74) Representative: **Pears, David Ashley et al, REDDIE & GROSE 16 Theobalds Road, London WC1X 8PL (GB)**

(54) **Data processing system with system bus for transfer of information.**

(57) A CPU (10) communicates with various devices on a system bus (11) and communicates with two further groups of devices by way of interfaces (14) and (14A) and corresponding buses (15) and (15A) whose timing and control characteristics are different from each other and from those of the system bus (11). The interface (14) polls the devices which may be on its bus (15) and keeps a record of the devices actually present. When access to a device is required, the interface (14) provides access via its bus (15) if the device is recorded as present on that bus. Otherwise it provides a signal to the interface (14A) to enable access via the corresponding bus (15A). The bus (11) operates with a two-phase cycle and a device requesting access to the bus does so in the first phase of a cycle and asserts a signal preventing other devices putting data on the bus. A device putting data on the bus in the second phase asserts a signal locking out other devices and a further signal keeps the bus locked if the time taken for the data transfer is such as to extend into the next operating cycle.

## DATA PROCESSING SYSTEM WITH SYSTEM
## BUS FOR TRANSFER OF INFORMATION

The present invention relates to a data processing system having a central processor unit, a memory unit, an input/output unit, a system bus for providing transfer of information between the said units, and means for providing a system bus operating time signal each cycle of which includes a first time phase and a second time phase.

The invention is concerned with preventing simultaneous access to the system bus by two competing units of the system.

The invention is defined in the appended claims.

In the preferred embodiment the system bus protocol permits a system component to obtain control of the system bus directly without the requirement for a bus control decision to be made by the central processor unit, so long as all other system components have indicated that the system bus is ready for access and so long as no other system component has asserted a signal indicating its refusal to relinquish prior control of the system bus.

The system also has the capability for providing communication with peripheral devices via more than one input/output (I/O) bus. For example, the system in a preferred embodiment provides a system I/O interface unit which includes means for identifying all devices which are currently present on a selected one of the I/O buses using unique "polling" techniques for such purposes as discussed below. Further, the system I/O interface unit is arranged to provide direct control of the transfer of information through the system I/O interface unit to the selected bus which has been polled and indirect control of an auxiliary interface unit for providing transfer of information through the auxiliary unit to another selected bus which has not been polled.

The invention will now be described in more detail, by way of example, with reference to the acccmpanying drawings, in which:

Fig. 1 is a broad block diagram of an overall system in accordance with the invention;

Figs. 2-4 are block diagrams of exemplary logic useful in controlling system bus protocol for the system of Fig.1;

Figs. 5 and 5A are a block diagram of the system I/O interface unit of Fig. 1;

Fig. 5B is a more specific block diagram of a portion of the system I/O interface unit of Figs. 5 and 5A;

Fig. 6 is a more specific logic diagram of the master control finite state machine and control logic of Figs. 5 and 5B;

Fig. 7 is a more specific logic diagram of the microNOVA finite state machine and control logic of Figs. 5A and 5B; and

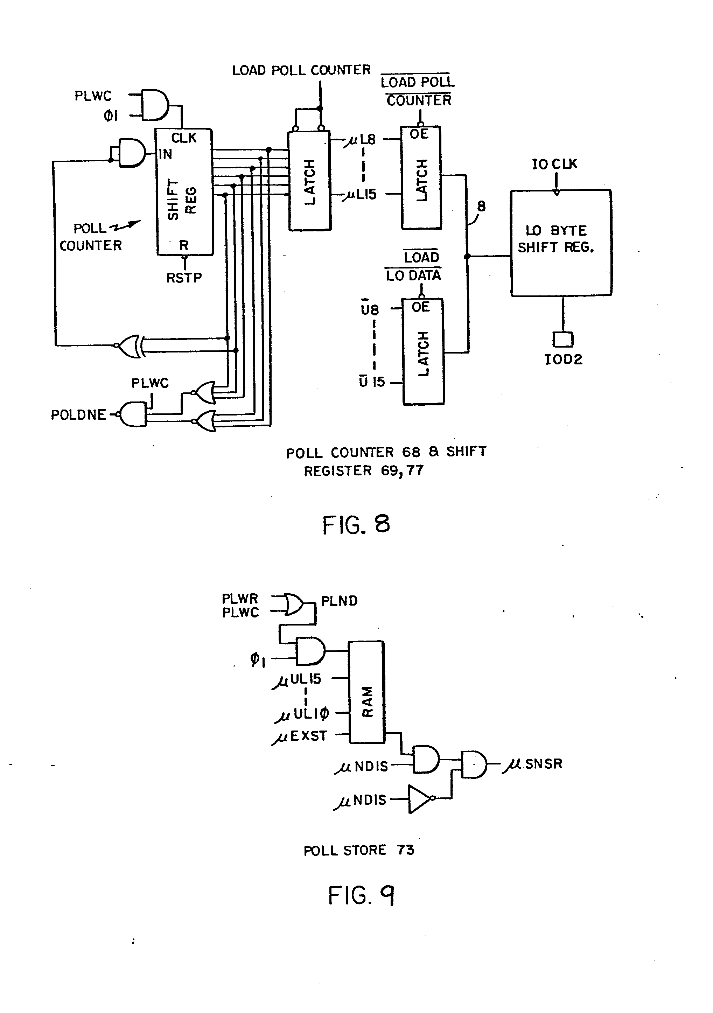

Figs. 8 and 9 show more specific logic diagrams of the microNOVA polling logic of Figs. 5, 5A and 5B.

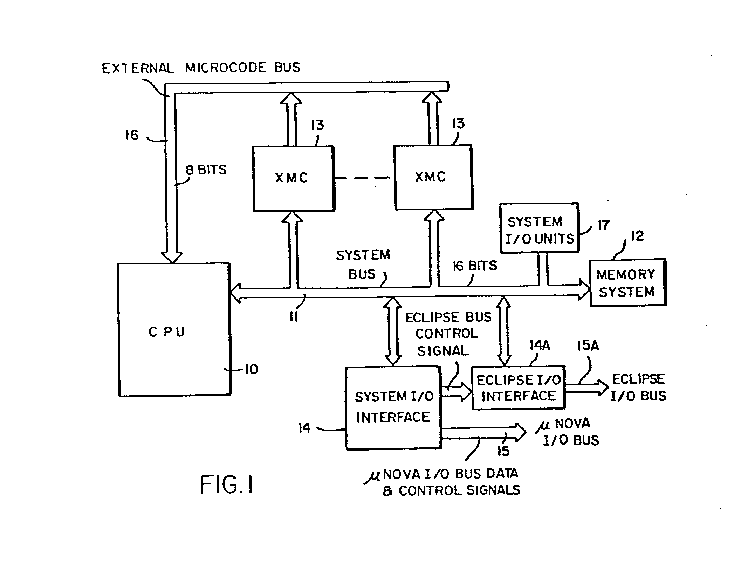

An overall system using the techniques of the invention is shown in Fig. 1 wherein a microprocessor chip 10 (identified as a central processor unit or CPU in the figure) is interconnected via an appropriate system bus 11 with a memory system 12, one or more system /IO units 17, one or more external microcontroller chips 13 (identified as "XMC" chips) and a system input/output interface unit 14 (identified as the system I/O interface) and a further interface unit 14A (identified as ECLIPSE ® I/O interface) which latter units interface with appropriate buses 15 and 15A for external input/output devices. For example, in a particular embodiment the system is designed to operate with peripheral (I/O) units of the microNOVA type as used with microNOVA ® computer systems as made and sold by Data General Corporation of Westboro, Massachusetts and with peripheral (I/O) units of the ECLIPSE ® type as used with ECLIPSE ® computer systems made by Data General Corporation.

Information transfer (i.e., addresses, data, instructions, etc). to and from the CPU from system components other than the CPU, such as one or more memory units and one or more input/output (I/O) devices, takes place on the 16-bit system but 11 either directly or via interface units 14 and 17. An effective system bus protocol must be utilized in order to provide for the correct transfer of such information. In this connection, each bus transaction comprises two segments, one of which can be identified as a "specifier" segment and the other of which can be identified as a "data" segment.

The timing of the system operation is synchronized by two externally generated clocks, identifiable as phase-1 ($\phi$-1) and phase-2 ($\phi$-2) clocks. The clocks divide a microcycle time period (sometimes referred to as a "T-period") into a $\phi$-1 portion and $\phi$-2 portion.

During the specifier segment the bus is used to describe the type of bus cycle operation which is occurring (e.g., a memory reference operation or an I/O operation) and information describing the target of the transaction (e.g., an address for a memory reference operation). The specifier segment always occurs during the first $\phi$-1 portion of a bus transaction and cannot be extended. During the data segment the bus is used to transfer data as, for example, to or from the addresses or I/O devices specified in the specifier segment. The data segment begins in the first $\phi$-2 portion of a bus transaction and may be extended by an integral number of additional microcycles (each having $\phi$-1 and $\phi$-2 portions). The $\phi$-1 and $\phi$-2 portions of the T-period may generally be separated by an essentially fixed time gap (e.g. 15 nanoseconds) and, at any rate, must be set up so as to provide no overlapping of the phases.

In operation, a particular system component may be transferring data on the system bus during the data segment of its bus transaction while another component waits to transfer an address during the $\phi$-1 portion of the specifier segment of the next bus transaction. In time-multiplexed systems of the type described here, frequent bus "turn-around" operations of this nature give rise to problems. Because of delays in various logic components used in the operation of the system, the transfer of data during the data segment of one bus transaction may not be fully completed by the start of the $\phi$-1 portion of the specifier segment of the next bus transaction. Accordingly, the second component may attempt to place its address on the system bus before the data transfer for the previous component has been completed.

Such a condition will produce a relatively high instantaneous surge of current which will tend to have an adverse effect on the system. For example, if system components are formed as TTL circuitry, the current surge will tend to cause undesirable noise effects, i.e., electromagnetic interference, to occur throughout the system as well as tending to provide a long-term adverse impact on the TTL components themselves. Further, if the CPU is formed as an integrated circuit chip, for example, by MOS techniques, such a current surge will also adversely impact upon at least the long term, and possibly the short term, reliability of the MOS chip. Therefore it is necessary to devise an appropriate technique for avoiding any overlapping of the system component bus driver operations which may result from the action of two different components at a bus turnaround operation in attempting to access the bus simultaneously (a "bus fighting" condition).

One previous solution to such problem has been to utilize a "dead" cycle (i.e. a non-operating cycle) at a bus turn-around operation, e.g., between the completion of each data transfer operation and the start of the next operating cycle, such as an address transfer operation, or vice-versa. During such dead cycle no information can be driven on to the bus and the bus in effect is idle. However, the presence of an extra dead cycle under such conditions either will require a basic microcycle clock of much higher resolution or will cause the operation of the overall system to be slower than desired. Accordingly, the use of a dead cycle is generally an undesirable approach to the problem.

Another proposed solution to the problem is to widen the separation between the two time phases, $\phi-1$ and $\phi-2$, of the T-period. However, the use of a wider gap lengthens the overall T-period and, accordingly, slows the system down to an even greater extent.

In accordance with the system discussed here the bus access overlap problem is avoided by the suitable generation of an address enable signal (ADREN) and a data enable signal (DATEN). The assertion of an ADREN signal indicates that a valid address is present on the system bus, while the assertion of a DATEN signal indicates that data is present on the system bus. If a DATEN signal is asserted, the address drivers of all other units which are capable of placing an address on the system bus are inhibited from operation. In a similar manner all data drivers are inhibited so long as an ADREN signal is asserted.

The ADREN signal is generated by the system component which has requested the current bus cycle to be started and indicates that information describing the type of bus cycle operation which is occurring has been placed on the bus. The particular system as described herein, for example, can initiate one of four different types of bus cycle operations, namely, a program memory reference, a console memory reference, an I/O operation, or a local memory reference operation. When the ADREN signal is asserted the system identifies which of the above four operations is to occur by placing an appropriate 16-bit word on the bus together with an additional bit as described below.

Thus, for a program memory reference the 16-bit word comprises a 15-bit address in bit positions 1-15, while bit Ø of the word is used in conjunction with an additional bit supplied at an additional pin, designated as the memory cycle (MEMCYC) pin, as follows:

| MEM CYC | | O | 1 | ADDRESS | 15 |
|---------|--|---|---|---------|-----|

TYPE OF OPERATION

In the system described, for example, the memory references may be to a standard NOVA/Eclipse logical address space to be used for program execution in NOVA and Eclipse computers made by Data General Corporation, Westboro, Massachusetts, the operation of which is well known to the art. For such program memory reference, the states of the MEMCYC and bit Ø pins identify the program memory reference operation, while the remaining 15 bits comprise the logical address for the memory reference. The combination of the MEMCYC and bit Ø states are used to define each of the four system operations involved, as follows:

| MEMCYC | BIT Ø | OPERATION |
|--------|-------|-----------|
| O | O | I/O Operation |
| O | 1 | Local Memory Reference |
| 1 | O | Program Memory Reference |
| 1 | 1 | Console Memory Reference |

In the case of console memory operation which relates to address space used to store software for console operations, for example, the MEMCYC and bit Ø pins define the console memory reference operation while again the remaining 15 bits define a console address. The local memory reference relates to address space which contains instructions for implementing inter-system communications (e.g., communications between the system CPU and other processors, etc.) and accordingly the system operation word includes a 15 bit local memory address. The I/O operation format which is placed on the system bus is discussed in more detail later.

When the bus type operation descriptor (i.e., the appropriate address or I/O function definition) is placed on the bus the ADREN signal is asserted. When whatever data involved is to be transferred on the bus, for example, during $\phi$-2 of the bus cycle, the ADREN signal is no longer asserted. The DATEN signal is asserted to indicate that a data transfer is taking place on the system bus so that all address drivers on the system are inhibited from operation, as mentioned above. The DATEN signal is supplied by the particular system component which is supplying the data which is being placed on the system bus.

The use of ADREN and DATEN signals for such control protects against the bus fighting condition which occurs during bus turnaround operations because of time delays in the system logic and, accordingly, improves the reliability of the system whether used with TTL logic or MOS chips.

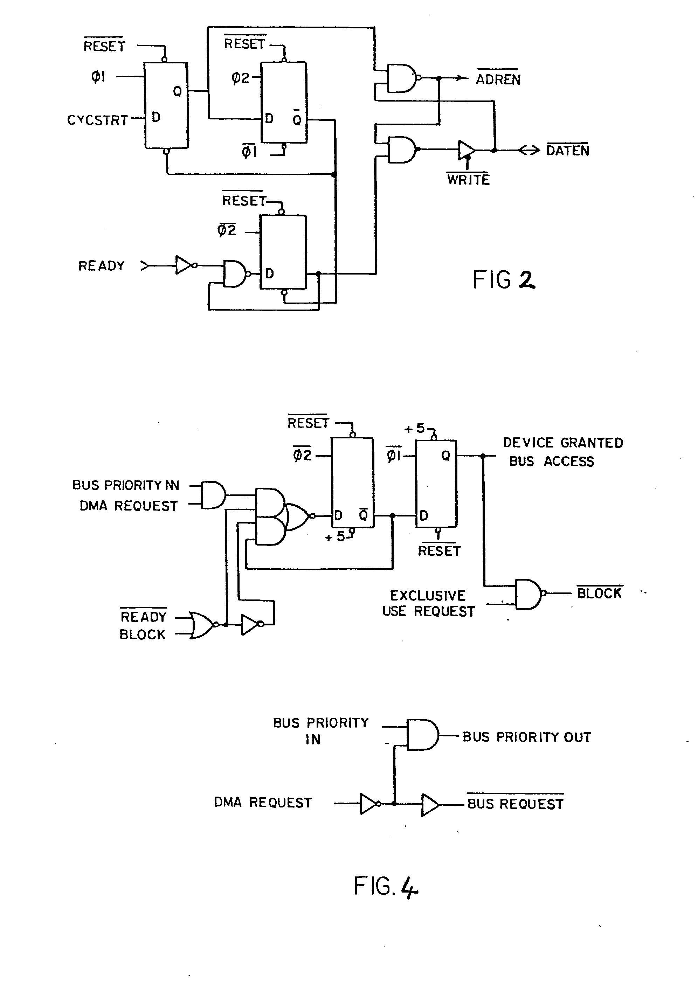

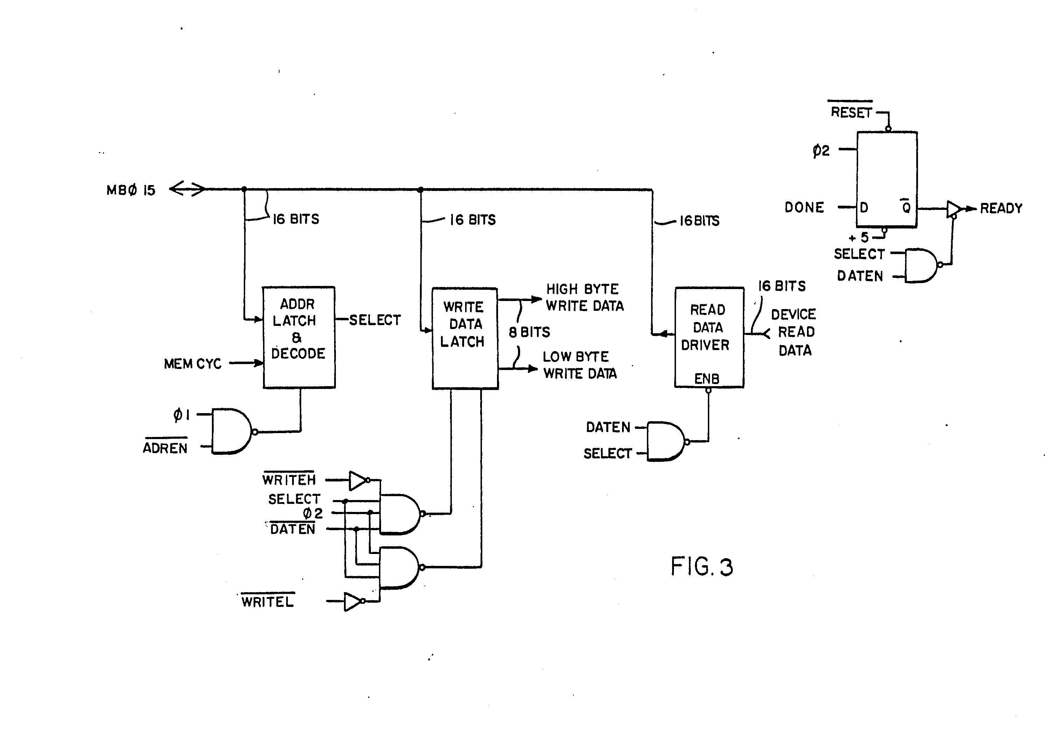

The system can be utilized with memories having different operating time cycles. If data at the address signified in $\phi$-1 is to be transferred between the CPU and a memory unit external to the CPU, for example, the data must be available for driving on to the bus during the subsequent $\phi$-2 so that the transfer can be completed therein. If the data is ready, the memory unit asserts a READY signal at the end of the $\phi$-2 portion of the current cycle during which the data has been driven on to the bus and the data transfer has been completed. If the data is not available and has not been driven on to the bus for transfer by the end of the $\phi$-2 portion of the current T-period, the READY signal is not asserted and the bus cycle operation is extended causing the DATEN signal to remain asserted for one, or more, T-periods, as necessary, until the data is available and ready for transfer. Logic for generating the READY SIGNAL, the ADREN signal and the DATEN signal is shown in FIGS. 2, and 3.

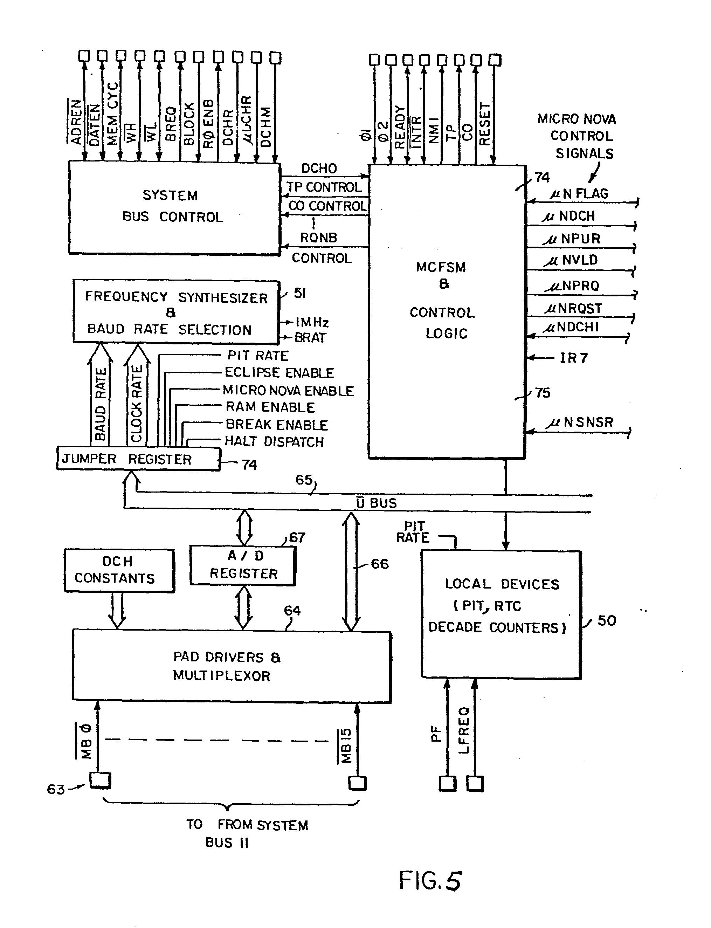

Further, if the system component which has control of the system bus for a data transfer operation does not intend to relinquish such control, such component must assert a bus locking signal (B/LOCK) in order to maintain control of the bus until the operation it is performing has been completed. For example, a system component may wish to read data, modify the data in some way, and return the modified data to the component for use or for storage, an operation sometimes referred to as a read-modifying-write (RMW) operation. Accordingly, such component can not give up control of the bus until the data has been modified and returned to the component, an operation which may require one, or more, T-period cycles. In such situation the system component which is performing the RMW operation asserts a B/LOCK signal until the overall RMW operation has been completed. Such assertion prevents any other unit from obtaining control of the bus. An exemplary logic circuit for generating the B/LOCK signal is depicted in FIG. 4.

Any unit which is in communication with the system bus can be made master of the bus whenever a current bus cycle operation, if any, terminates, control of the bus being relinquished at the beginning of the next T-period, (i.e., so long as a READY signal has been asserted by any unit utilizing the current bus cycle and so long as no B/LOCK signal has been asserted by another unit). Thus, a unit which desires master bus control monitors the READY signal and the B/LOCK signal, request control of the bus by asserting a bus request (BREQ) signal and is permitted to gain control of the bus under the above described conditions of the READY and B/LOCK signals. Such unit maintains control until it no longer asserts the BREQ signal, so long as a device having a higher bus priority does not also request control of the bus at the end of any bus cycle.

In this way bus control is handled by the unit which desires the control rather than by the CPU. In previous systems bus control is normally handled by the CPU which must entertain a bus request from an external unit and subsequently decide whether or not to provide a "bus grant" signal, or its equivalent. Such a decision-making process by the CPU requires a relatively long time due to the propagation delays of the signals required between the CPU and the various system components with which the CPU must communicate in order to make its decision. In accordance with the procedure used in the system of the invention, i.e., where the unit itself generates a BREQ signal and under the proper conditions thereupon receives control of the bus, bus control requests are handled in a much faster manner and bus control can be handed over to the requesting unit much sooner.

As mentioned above, each of the different types of bus operation require the utilization of the MEMCYC pin which, together with bit $\emptyset$ of the bus cycle description word (i.e., an address or I/O operation word), defines the type of operation which is to be performed. In accordance with the operation chart set forth above, I/O operations are defined when the MEMCYC and bit $\emptyset$ of the address word are both zero. For such operating condition the following word format for I/O operations is placed on the system bus:

| MEM CYC | 0 | 1 | 2            4 | 5   6 | 7 | 8   9 | 10            15 |
|---------|---|---|----------------|-------|---|-------|------------------|
| 0 | 0 | 0 | SYS. I/O AND DCH FUNCTIONS | I/O PORT | DIR | S/C/P | DEVICE CODE |

The above I/O instruction effectively represents a re-encoded version of the standard NOVA®/Eclipse® I/O instruction format received at the CPU, the re-encoded instruction being placed on the bus during the cycle description portion of the current bus cycle. The original microNOVA®/ECLIPSE® I/O instructions are re-encoded as above in order to facilitate the design of the interface logic between the CPU and the I/O devices.

As can be seen therein, bit $\emptyset$ is utilized in conjunction with the MEMCYC pin to define the I/O operation. Bit 1 is a non-used bit which has been reserved for possible future use. Bits 2-4 are utilized to define the system, I/O and data channel (DCH) functions as follows:

| BIT 2 | BIT 3 | BIT 4 | FUNCTION |
|-------|-------|-------|----------|
| 0 | 0 | 0 | NOP |
| 0 | 0 | 1 | INTA |
| 0 | 1 | 0 | MASKO |
| 0 | 1 | 1 | IORST |
| 1 | 0 | 0 | DCHA |
| 1 | 0 | 1 | DCHI |
| 1 | 1 | 0 | DCHO |
| 1 | 1 | 1 | Reserved |

Bits 5 and 6 define the I/O port which is utilized as follows:

| BIT 5 | BIT 6 | PORT |
|---|---|---|
| O | O | Status |
| O | 1 | A |
| 1 | O | B |
| 1 | 1 | C |

Bit 7 defines the direction of the transfer as follows:

| BIT 7 | DIRECTION |
|---|---|
| O | OUT |
| 1 | IN |

Bits 8 and 9 define the control option which is being utilized, i.e., either a start, a clear, or a pulse operation in accordance with normal ECLIPSE® operations as follows:

| BIT 8 | BIT 9 | FUNCTION |
|---|---|---|
| O | O | NONE |
| O | 1 | START |
| 1 | O | CLEAR |
| 1 | 1 | PULSE |

Bits 10-15 define the 6-bit device code which identifies a particular I/O device which is to be utilized during the I/O operation. The above operations are as defined, for example, with previously known ECLIPSE® computers and, being known to those in the art, need not be defined in further detail.

The use of the above I/O instruction format requires less external logic for handling I/O instructions than was normally required for the handling of I/O instructions using the known previous ECLIPSE® instruction format. The type of operation, i.e., a memory reference or a I/O operation, is appropriately flagged (by the MEMCYC and bit $\emptyset$ states) and, if it is an I/O operation, the I/O instruction is sent in accordance with the above format in order to ease the interface operation.

In this connection one particular combination of bits in an I/O instruction is of some significance since it extends the capability of the I/O operation over that previously available to ECLIPSE® systems. Thus, as can be seen, the I/O ports include not only the normal A, B and C ports utilized in ECLIPSE® systems but also identifies an additional port capability defined as the "Status" port, the use of which is described below.

Thus, if the I/O instruction identifies a STATUS port in the port field (bits 5, 6 are 0,0) and an IN direction in the direction field (bit 7 is 1), such instruction operates as a request to the identified device (identified by device code bits 10-15) to provide information as to its status. The device then returns data in the following format:

| 0 | 1 | 2 | 3 | 15 |
|---|---|---|---|---|
| BUSY | DONE | POLL | RESERVED | |

The device indicates its presence on the system bus by the state of the poll bit 2, and further indicates its "busy" or "done" state by bits 0 and 1, respectively. In addition the device has 13 reserved bits for use in providing further information.

Such format contrasts with the previous ECLIPSE® instruction format which did not permit the inclusion of such status information (thereby requring two extra wires for separately generated "busy" and "done" flags) and which was not adaptable for "polling" (i.e., obtaining an indication of the presence of a device on the system bus) as is helpful in the present system described herein.

Accordingly, the revised I/O instruction format, which is supplied to the system bus and which does not require the inclusion of accumulator bits (which are already identified for the CPU by the standard I/O instruction received thereat) provides for the further ability to transfer data not provided for by the standard microNOVA®/ECLIPSE® I/O instruction format.

## System I/O Interface Unit

As can be seen in FIG. 1, the system CPU is arranged to be capable of communicating with I/O devices on a plurality of different buses. For example, the CPU may communicate with I/O devices directly on the system bus 11, with I/O devices on bus 15A designated in a particular embodiment, for example, as the ECLIPSE® I/O bus for ECLIPSE® I/O devices, or on bus 15B designated in a particular embodiment, for example, as the MicroNOVA® bus for microNOVA® devices. In accordance with the system described herein, data can be transferred directly to and from the system I/O devices via the system bus 11, as described in more detail below, while data for ECLIPSE® I/O devices are transferred to and from such devices via ECLIPSE® bus 15A through a separate ECLIPSE® I/O interface unit 45, the transfer thereof being controlled by control signals from the system I/O interface unit 14. Further, data for the microNOVA® I/O devices are transferred to and from such devices on the microNOVA® bus 15B through the system I/O interface unit.

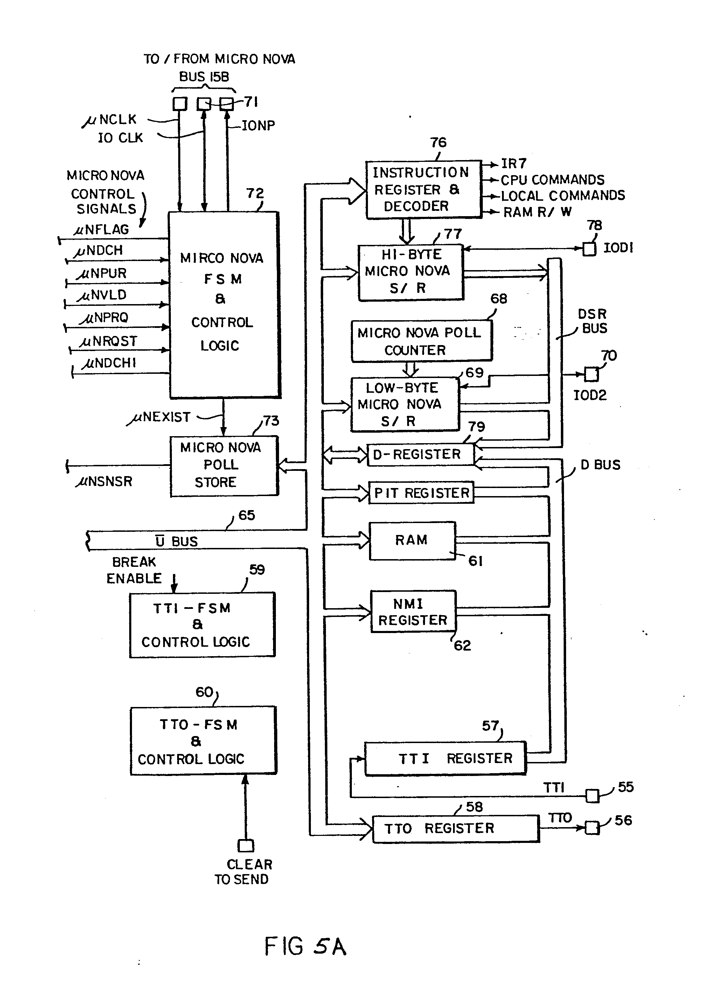

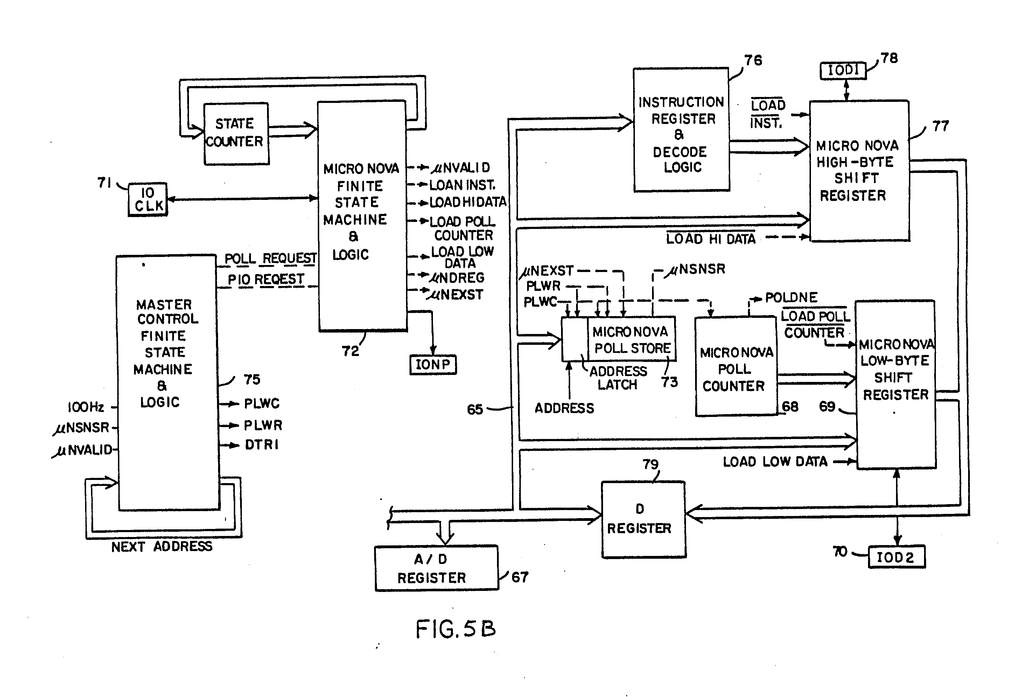

A more detailed block diagram of the system I/O interface unit 14 is shown in FIGS. 5 and 5A. A further, even more detailed, block diagram of the microNOVA® bus control logic for address/data transfers and for microNOVA® polling operation (as discussed in more detail below) is shown in FIG. 5B. As can be seen therein, the system I/O interface unit comprises a plurality of local, or internal, devices and various control logic circuits, shown as block 50, the devices being of the type which are already known and used with respect to previously available systems. For example, the internal devices of the system I/O interface unit 14 may include devices of the type utilized in the Data General Corporation ECLIPSE® computer systems, as shown and discussed with reference to the following publications:

ECLIPSE® M/600 Principles of Operation
No. 014-000092

ECLIPSE® S/250 Programmer's Reference Manual
No. 014-000611

Interface Designer's Reference
NOVA® and ECLIPSE® Line Computers
No. 015-000031

microNOVA® Integrated Circuits Data Manual
No. 014-000074

The above publications are representative of publications available from Data General Corporation, Westboro, Massachusetts concerning NOVA®, ECLIPSE®, and microNOVA® systems made and sold by Data General Corporation. Such publications contain information useful as background information in understanding not only the aforementioned internal devices but also various other aspects of the system being described herein.

Thus, such devices may include a "programmable interval timer" (PIT) unit which provides a programmable timing signal which produces clock signals at a counter clock rate at one of four selectable frequencies, for example. In a particular embodiment, for example, the programmable interval time can be arranged to produce counter clock intervals at 1 MHz, 100 KHz, 10 KHz or 1 KHz from a constant input clock signal of 1 MHz through well-known frequency divider techniques.    In the system I/O unit, such timer responds to a pseudo-constant 1 MHz signal which is derived from a frequency synthesizer unit 51, as discussed in more detail below.

The local devices may also include, for example, a "real time clock" (RTC) unit which generates timing pulses that are independent of the system clock rate.    The real time clock can interrupt at any one of four selectable frequencies, for example, at the AC line frequency, or at 10 Hz, 100 Hz or 1000 Hz the latter three clocks all derived from the pseudo-constant 1 MHz signal through well-known frequency divider techniques.

The internal devices may also include a power monitor unit which detects any transition of a power monitor pulse which indicates that AC power has failed or that AC power has returned after a momentary power failure, or that a start up power condition exists.

The system I/O interface unit also includes appropriate input and output interface logic via which serial data can be asynchronously supplied (as from a teletype unit, for example), such inputs and outputs being supplied via TTI pin 55 and TTO pin 56, respectively, and from input and output registers 57 and 58, respectively, in a controlled manner in accordance with standard practice uitilizing suitable finite state machine (FSM) and control logic 59 and 60.    As in prior art devices utilizing asynchronous, serial data terminal inputs and outputs, the terminal unit may operate at selectable baud rates, the available baud rates being selected from a large number of such rates ranging in a particular case from 50 baud to 38400 baud, for example.    For such purpose in this system the baud rate signals are derived from a pseudo-constant 614,400 Hz master baud rate signal, also obtained from the frequency synthesizer unit 51.    The selected baud rates can be obtained therefrom though suitable baud rate selection logic in accordance with well-known techniques of prior art systems which utilize such

0094140

asynchronous, serial data input and output operation.

The internal units and the terminal logic discussed above do not form a part of the inventive aspects of the system I/O interface unit 14 and need not be described in further detail.

For convenience, an appropriate random access memory (RAM) storage unit 61 may also be present on the system I/O interface unit for providing temporary storage space which may be used, for example, when performing console operations. Such storage unit is of a well-known RAM type which can be formed to provide storage space of an appropriate size for the desired console use. For example, a particular embodiment may be capable of storing a selected number of 16-bit words for such purpose. As such, the RAM unit 61 does not form a part of the inventive aspects of the system I/O interface unit 14 and need not be discussed in more detail. Further a non-maskable interrupt (NMI) register 62 for use as described in the aforesaid ECLIPSE® and microNOVA® documents may also be part of the system I/O interface unit 14 but does not form a part of the inventive aspects thereof and need not be described in further detail.

Addresses and data are supplied to and from the system bus 11 at the system I/O interface unit 14 in the form of 16-bit words ($\overline{\text{MB } \emptyset\text{-15}}$) supplied at the physical address/data (PADS) pins 63. Suitable driver and multiplexer circuits 64 are utilized for such purpose, the address and data words which are being transferred to or from the system bus being supplied to internal $\overline{\text{U}}$ bus 65 for use in the system I/O interface unit 14 either directly via an internal bus 66 or indirectly via temporary address/data register 67 which may be used for temporary storage thereof before such addresses and data are supplied to the system I/O interface unit or to the system bus depending on the direction of transfer thereof.

The I/O buses which must be used to transfer addresses and data between the CPU and the I/O devices with which the CPU may desire communication differ depending on which type of I/O devices are involved (e.g., ECLIPSE® devices which communicate via ECLIPSE® bus 15A, microNOVA® devices which communicate via microNOVA® bus 15B and all other devices which communicate via system bus 11). The system I/O interface unit 14 must decide which I/O device is involved and, hence, which I/O bus is to be used for the transfer of such data so that the interface unit control can control such transfer to and from the CPU. In accordance with the system of the invention disclosed in FIGS. 5 and 5A, and the more detailed block diagram of FIG. 5B, the system I/O interface unit 14 contains logic circuitry for identifying all of the devices which are on a selected one of the two buses which it controls, namely, buses 15A or 15B. Such identification can be achieved by appropriately "polling" the selected one of such buses and storing suitable information as to which devices are on the selected bus.

In accordance with a specific embodiment of the invention which utilizes either a microNOVA® I/O bus 15B or an ECLIPSE® I/O bus 15A, the system I/O interface unit is arranged to "poll" the microNOVA® I/O bus 15B to determine which devices are on such bus. A suitable microNOVA® poll counter 68 supplies each of the expected device code words which identify the various devices which are likely to be used with the system, which device code words, for example, are 6-bit device codes supplied to the microNOVA® I/O bus 15B via "low-byte" (a byte is 8 bits) shift register 69 from poll counter 68 to the output microNOVA® bus pin 70 identified as IOD2 in FIG. 5A. The 6-bit device codes are supplied in parallel to shift register (S/R) 69 during the polling process and are in turn supplied serially to the microNOVA® bus from shift register 69.

When microNOVA® I/O devices, which communicate with the CPU on the microNOVA® bus 15B, are interrogated with a device code signal for identification thereof, such devices supply a return identifiable I/O clock (IOCLK) signal at pin 71 to microNOVA® finite state machine and control logic 72 if a device matching a particular device code is present on the microNOVA® bus. Such operation is in contrast with devices on the ECLIPSE® bus 15A for which no such identifiable I/O clock signal would be present if such devices were interrogated with the device codes. Because of such contrasting operations microNOVA® devices can be "polled" to determine their presence on microNOVA® bus 15B and a record of their presence kept in the system I/O interface unit 14.

Thus, receipt of an IOCLK signal at pin 71 from a

0094140

particular I/O device on the microNOVA® bus is supplied to control logic in the microNOVA® finite state machine and control logic unit 72. Such logic generates a microNOVA® exist signal (sometimes referred to as μNEXST) for supply to a microNOVA® poll register 73 to indicate that an I/O device having such device code is present on the microNOVA® bus.

The microNOVA® poll store register 73, for example, is a 64-bit register, each bit correspondong to a particular device code (in particular embodiment there being up to 64 possible microNOVA® devices which can be present on the microNOVA® bus). If a 6-bit device code representing a specified device which has been interrogated is provided at the input thereto from microNOVA® poll counter 68, the particular bit associated therewith will be placed in a state which indicates the presence or absence of such device on the microNOVA® bus, depending on whether a μNEXST signal is so generated. Accordingly, when all of the device codes have been polled, the microNOVA® poll register 73 contains information as to the presence of all devices which are on the microNOVA® I/O bus 15B.

Polling of the microNOVA® bus is first performed at "start-up", the complete set of 64 possible devices in a particular embodiment, for example, being polled during one overall polling time interval before the ovarall system is put into operation. If, for example, the polling of each device takes 10 microseconds, or less, the complete poll can be accomplished in 600-700 microseconds. Once the system is in operation, updating of the poll store can be accomplished as devices previously indicated as not being present are turned on and devices previously indicated as present are turned off. Such updated polling can be accomplished at a 100 Hz rate, a single device being polled each .01 seconds (a completed update polling of all devices occurs every 0.6-0.7 seconds, for example).

In some cases a device will be turned on and could, therefore, be present on the microNOVA® bus but the poll store may not indicate its presence (the updating for such device may not yet have occured since the device came on line after the last update poll. If, under such condition, the device requests an interrupt operation, the interrupt request itself indicates the presence of the device and the microNOVA® poll register is automatically updated by appropriate gating· in the microNOVA® finite state machine logic which provides a µNEXST signal to the poll register.

All devices which are not identified as being on the microNOVA® I/O bus, but which are in communication with the system, will by the process of elimination be either on the ECLIPSE® I/O bus 15A or on the system bus 11. As will be noted, a jumper register 74 is arranged so that an ECLIPSE® ENABLE and/or a microNOVA® ENABLE is provided. The presence or absence thereof is controlled by the presence or absence of a suitable "jumper" connection being reflected by the state of the "jumper" register 72. The following chart summarizes the conditions for identifying the devices involved:

| MicroNOVA® ENABLE | ECLIPSE® ENABLE | System | ECLIPSE® | MicroNOVA® |
|---|---|---|---|---|
| O | O | Yes | No | No |
| O | 1 | E | E | No |
| 1 | O | Yes | No | Yes |
| 1 | 1 | E | E | Yes |

In the first condition where neither jumper connection is enabled the only devices identifiable are "system" devices. Where the ECLIPSE® jumper is enabled but the microNOVA® jumper is not, the system generates the ECLIPSE® timing signals (signified as "E") but the interface unit 14 does not determine whether the devices are ECLIPSE® or system devices. Where the microNOVA® jumper is enabled but the ECLIPSE® jumper is not, both microNOVA® and system devices are identifiable. Where both jumpers are enabled, microNOVA® devices can be identified but the system interface unit does not determine whether the devices are ECLIPSE® or system devices (the ECLIPSE® timing signals are generated). Accordingly, the polling technique permits the system I/O interface unit 14 to determine whether a particular I/O device must be communicated with either on the microNOVA® I/O bus or on one of the other buses. If a microNOVA® device is present on the microNOVA® bus, its presence is indicated by the microNOVA® poll store unit 73 which provides a microNOVA® sensor signal, µNSNSR, to modify the operation of a master control finite state machine 75 so that its next state of operation provides the necessary control signals to control the operation of the microNOVA® finite state machine 73 for microNOVA® operation. Control signals are shown in FIG. 5B for performing the polling process. The low byte shift register 69 is loaded with the device code at the assertion of LOAD POLL COUNTER by the microNOVA® FSM 72, the poll count beginning at a poll count signal PLWC which increments the poll counter. The high byte shift register is loaded with a suitable instruction which can be selected to produce the least effect on the system (e.g., an IOSKP instruction in which data in all registers remain unchanged, etc.) at the assertion of a LOAD INST signal. If a return IOCLK is received at pin 71 a μNEXST signal is asserted by the microNOVA® FSM 72 which signal, together with the device code applied to the address latch of the poll store 73, provides the indication of the presence of the particular device involved. When the complete poll count is completed for start-up, for example, a POLDNE signal is asserted by poll counter 68 for supply to the microNOVA® FSM 73.

The PLWR signal is used on "interrupts" by a device when the CPU acknowledges the interrupt request by such device by asserting an interrupt acknowledge signal. At the assertion of a suitable interrupt acknowledge signal the device itself updates the poll store, via the supplying of its device code and the supplying of the PLWR signal by the master control PSM to the poll store.

For a poll store read operation, when an ADREN signal occurs, the poll store is accessed by the device code if an I/O instruction is present. The poll store then provides a μNSNSR signal to the master control FSM is such device is present.

A poll update request signal (μPUR) is supplied from the master control FSM 75 at the 100 Hz rate as determined by a 100 Hz input counter signal.

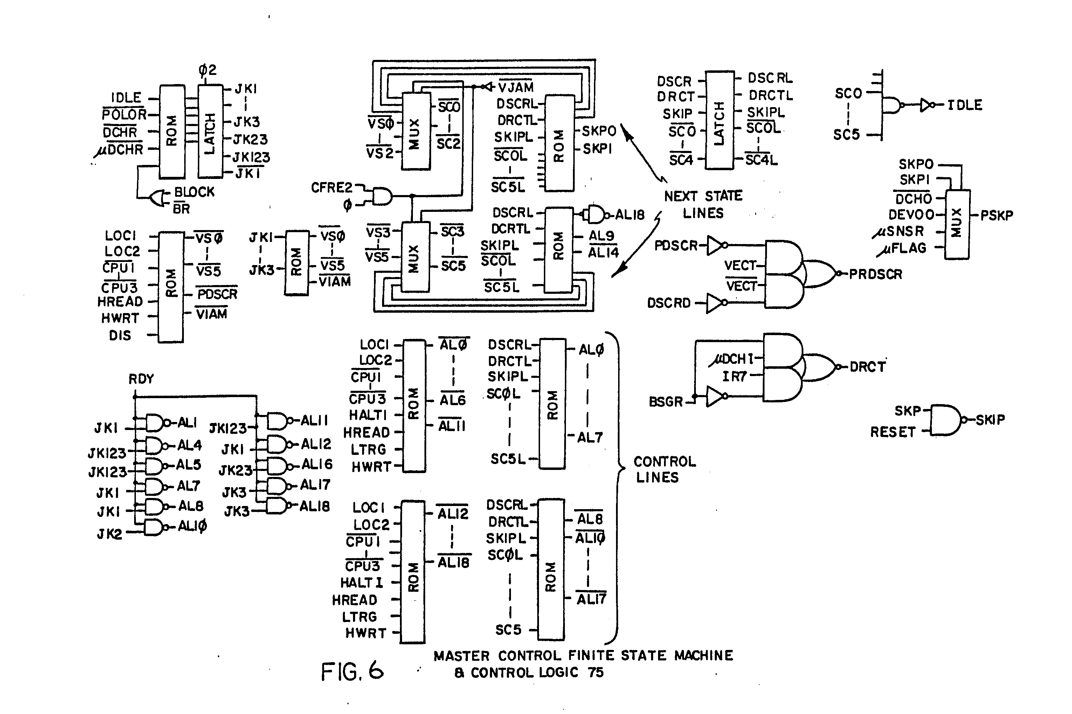

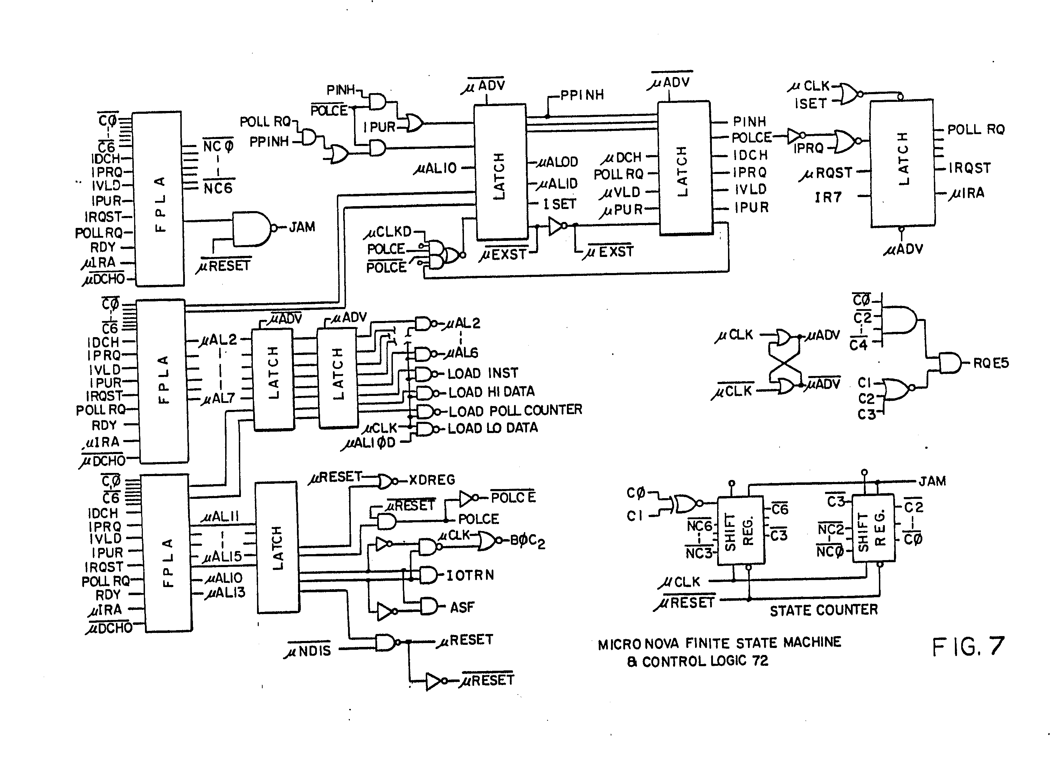

The required microNOVA® instruction register and decode logic 76 and the microNOVA® high byte register 77 for supplying the high byte at microNOVA® bus pin 78 (IODI) are also shown in FIGS. 5A and 5B, as well as D-register 79 for shifting data to and from the $\overline{U}$ bus 65 and the microNOVA® shifters 69 and 77, in accordance with standard microNOVA® operation already well known to the art. Specific logic for the microNOVA FSM and control logic unit 72 and the master control FSM and control logic unit 75 are shown in FIGS. 6 and 7, respectively. The poll counter 68 and shift registers 69 and 77 are shown in FIG. 11, while the poll store register 73 is shown in FIG. 12.

The system I/O interface unit 14 is designed so as to be capable of operation at more than one input system clock frequency and is, therefore, adaptable for use with a system wherein the system clock is not expected to remain at a single fixed frequency for all operations. The frequency synthesizer unit 51 is provided so as to be responsive to one of a plurality of different selected input frequencies to produce the desired internal clock frequency required for operation of the internal devices of the interface unit and the desired master baud rate signal for operation of the asynchronous terminal system. In a particular embodiment, for example, the internal clock signal must have a substantially constant frequency of 1 MHz so as to provide for correct operation of the internal, or local, devices (such as the PIT and RTC devices mentioned above) and a substantially constant selected baud rate derived from the substantially constant master baud rate signal for the asynchronous terminal input/output logic.

A full description of the frequency synthesis unit is contained in EP 0 035 334 (and in application No.          which, like the present application is divided out of 81 300 560, published as EP 0 035 334).

CLAIMS

1.      A data processing system having a central processor unit (10), a memory unit (12), an input/output unit (17), a system bus (11) for providing transfer of information between the said units, and means for providing a system bus operating time signal each cycle of which includes a first time phase and a second time phase;   characterised by means for generating at a unit (10 or 17) which is requesting access to the system bus (11) a first control signal (ADREN) when information defining the type of bus cycle operation, including address information, if any, is being transferred on the system bus (11) during the first time phase of a bus cycle operation;   other units being prevented by the first control signal from placing data on the system bus;   and means for generating at a unit acting as a data source in a bus cycle operation a second control signal (DATEN) when valid data is being transferred on the system bus (11) during the first or second time phase of the bus cycle operation from the source unit, and the presence of the second control signal inhibiting the placement of bus cycle operating information for transfer on the system bus by any other system unit until the transfer of the valid data has been completed with respect to the source unit.

2.      A data processing system in accordance with claim 1, further characterised by means for generating information for · deifning the type of bus cycle operation which is to occur, the information comprising a first plurality of bits (MEMCYC, BIT Ø) for identifying the bus cycle operation as a type of memory reference operation or as an input/output operation involving input/output units and a second plurality of bits identifying an address for a memory reference operation or identifying a selected instruction for an input/output operation.

3.      A processing system in accordance with claim 2, characterised in that the second plurality of bits comprise a first field (BITS 2-4) defining input/output and data channel operation, a second field (BITS 5,6) defining input/output ports for use during such input/output and data channel operations, a third field (BIT 7) defining the direction of a data transfer during such input/output and data channel operations, a fourth field (BITS 8,9) defining other selected operating control operations, and a fifth field (BITS 10-15) containing device code information identifying an input/output unit.

4.      A data processing system having a central processor unit (10), a memory unit (12) an input/output unit (17), and a system bus (11) for providing transfer of information between the said units;  characterised by bus request means in selected ones of the system units for generating a bus request signal, the generating unit obtaining exclusive access to the system bus (11) when its bus request signal is so generated so long as no other system unit has asserted a signal (DATEN) indicating that a previous data transfer operation with respect to that other system unit has not been completed and so long as no other system unit asserts a signal (B/LOCK) indicating that that other system unit is maintaining prior control of access to the system bus.

5.      A data processing system having a central processor unit (10) and a system bus (11) for providing ccmmunication with one or more memory units (12), characterised by a first interface (14A) providing communication between the system bus (11) and a first input/output bus (15A) in further communication with a first group of external units;  a second system interface (14) for providing communication between the system bus (11) and a second input/output bus (15) for further communication with a second group of external units, the second system interface (14) further including to the first interface (14A);  means (68-71) for identifying each of the external devices of the second group which are currently in communication with the second input/output bus (15);  means (73) for storing information which indicates the presence of each of the identified external devices of the second group thereof;  and means (74) responsive to the stored information for controlling the operation of the second system interface (14) to provide access to the identified external devices via the second input/output bus (15) and to provide a control signal to the first system interface (14A) to enable access to external devices on the first input/output bus (15A) when such devices are not identified as on the second bus (15).

6.      A data processing system in accordance with claim 5, characterised in that the identifying means includes a poll register means (68,69) for supplying coded information with respect to all external devices included in the second group; means responsive to information (IOCLK) generated in response to the coded information by each external device of the second group which is present on the second input/output bus (15) for producing a signal ($\mu$ NEXIST) which indicates that the external device is so present on the second input/output bus (15); and in that the storing means (73) is responsive to the last-named signal and to the coded information for storing information indicating the presence of external devices.

7.      A data processing system in accordance with claim 6, characterised in that the storing means (73) provides a sensing signal ($\mu$ NSNSR) identifying the presence of an external device on the second input/output bus (15) and further including bus control means (75) responsive to the sensing signal for providing selected control signals to permit access by the system bus means to the second input/output bus (15) via the second system interface (14).

FIG.1

0094140

FIG 2

FIG. 4

FIG. 3

0094140

FIG.5

FIG 5A

FIG. 5B

FIG. 6

MASTER CONTROL FINITE STATE MACHINE
& CONTROL LOGIC 75

7/9

0094140

MICRO NOVA FINITE STATE MACHINE & CONTROL LOGIC 72

FIG. 7

0094140

POLL COUNTER 68 & SHIFT
REGISTER 69,77

FIG. 8

POLL STORE 73

FIG. 9

0094140

European Patent
Office

**EUROPEAN SEARCH REPORT**

Application number

EP 83 20 0686

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| Y | IEEE TRANSACTIONS ON NUCLEAR SCIENCE, vol. NS-26, no. 4, August 1979, pages 4525-4530, New York, USA<br>R.W. DOWNING: "Fastbus - Details of addressing and bus mastership" * Page 4525, column 1, lines 35-40; column 2, lines 10-21; figure 1; page 4526, column 1, lines 4-12; page 4530, column 1, lines 12-17 * | 1-7 | G 06 F 3/04 |
| Y | IEEE TRANSACTIONS ON NUCLEAR SCIENCE, vol. NS-26, no. 1, February 1979, pages 679-685, New York, USA<br>R.S. LARSEN: "Status of the interlaboratory development of a high-speed standard data bus - Fastbus" * Page 679, column 2, lines 20-61; page 680, column 1; figure 2 on page 681; figure 7 on page 684; figure 9 on page 685 * | 1,4,5-7 | |
| | --- -/- | | TECHNICAL FIELDS SEARCHED (Int. Cl. ³)<br><br>G 06 F 3/04<br>G 06 F 13/00 |

The present search report has been drawn up for all claims

| Place of search | Date of completion of the search | Examiner |
|---|---|---|
| THE HAGUE | 24-08-1983 | DHEERE R.F.B.M. |

European Patent Office

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| Y | IEEE COMPUTER SOCIETY INTERNATIONAL CONFERENCE, COMPCON 75, 25th-27th February 1975, pages 27-30, San Francisco, New York, USA A. BAUM et al.: "Hardware considerations in a microcomputer multiprocessing system" * Page 27, column 2, lines 1-5; page 29, column 2, lines 21-30; page 30, column 1, figure 5 * | 1-3,5-7 | |
| Y | US-A-4 000 485 (HONEYWELL) * Column 1, lines 52-68; column 2, lines 1,2,61-68; column 3, lines 1-14, 39-65; column 4, lines 1-4, 21-68; column 5, lines 1-17; column 8, lines 27-66; column 13, lines 31-61; column 18, lines 1-18, 42-44; column 19, lines 63-68; column 20, lines 1-55; column 21, lines 19-40; figures 2-6,9,10 * | 1-4,6,7 | |
| Y | US-A-4 148 011 (GENERAL AUTOMATION) * Column 1, lines 63-66; column 2, lines 40-43; column 5, lines 66-68; column 6, lines 1,2; figure 1 * | 4 | TECHNICAL FIELDS SEARCHED (Int. Cl. ³) |

-/-

The present search report has been drawn up for all claims

| Place of search | Date of completion of the search | Examiner |
|---|---|---|
| THE HAGUE | 24-08-1983 | DHEERE R.F.B.M. |

# EUROPEAN SEARCH REPORT

European Patent Office

## DOCUMENTS CONSIDERED TO BE RELEVANT

Page 3

| Category | Citation of document with indication, where appropriate, of relevant passages | Relevant to claim | CLASSIFICATION OF THE APPLICATION (Int. Cl. 3) |
|---|---|---|---|
| Y | US-A-4 186 379 (HEWLETT-PACKARD) * Column 2, lines 1-8, 47-62; column 3, lines 11-31, 54-64; figures 3,4 * | 1 | |
| A | DE-B-1 082 947 (PHILIPS) | 1 | |
| | | | TECHNICAL FIELDS SEARCHED (Int. Cl. 3) |

The present search report has been drawn up for all claims

| Place of search THE HAGUE | Date of completion of the search 24-08-1983 | Examiner DHEERE R.F.B.M. |
|---|---|---|

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82